# DEMANDE DE BREVET EUROPEEN

(11) **EP 4 576 167 A1**
(43) Date de publication de la demande: **25.06.2025**
(21) Numéro de dépôt: 24221720.6
(22) Date de dépôt: 19.12.2024
(51) Int. Cl.: H01L 21/02

(54) **PROCÉDÉ D'ÉLABORATION ET DE TRANSFERT D'UN MATÉRIAU BIDIMENSIONNEL**

(30) Priorité: 21.12.2023 FR 2314917
(71) Demandeur: Commissariat à l'Energie Atomique et aux Energies Alternatives, 75015 Paris (FR)
(72) Inventeur: FOURNEL, FRANCK, 38054 GRENOBLE CEDEX 09 (FR); ROLLAND, EMMANUEL, 38054 GRENOBLE CEDEX 09 (FR); LE VAN-JODIN, LUCIE, 38054 GRENOBLE CEDEX 09 (FR); BRUNET, PAUL, 38054 GRENOBLE CEDEX 09 (FR)
(74) Mandataire: Cabinet Camus Lebkiri

(57) **Abrégé**

L'invention concerne un procédé d'élaboration et de transfert d'un matériau bidimensionnel, comprenant les étapes suivantes :
- croissance du matériau bidimensionnel sur une surface d'un substrat de croissance de sorte que le matériau bidimensionnel soit lié à la surface du substrat de croissance par des forces de van der Waals, la surface du substrat de croissance ayant un premier angle de contact avec une goutte d'un liquide ;
- fourniture d'un substrat cible, le substrat cible présentant une surface ayant un deuxième angle de contact avec une goutte du liquide, le deuxième angle de contact étant strictement supérieur au premier angle de contact ;
- assemblage du substrat de croissance et du substrat cible par collage direct entre le matériau bidimensionnel et la surface du substrat cible ; et
- rupture de l'interface entre le substrat de croissance et le matériau bidimensionnel par propagation d'une fissure interfaciale à l'interface entre le matériau bidimensionnel et le substrat de croissance, le front de fissure étant mouillé par le liquide.

## Description

### DOMAINE TECHNIQUE DE L'INVENTION

La présente invention se rapporte au domaine des matériaux bidimensionnels. L'invention concerne plus particulièrement un procédé d'élaboration et de transfert d'un matériau bidimensionnel.

### ARRIERE-PLAN TECHNOLOGIQUE DE L'INVENTION

Les matériaux bidimensionnels (2D), comme le graphène et les dichalcogénures de métaux de transition (MoS₂, MoSe₂, MoTe₂, WS₂, WSe₂...), se présentent sous la forme d'une monocouche (atomique ou moléculaire) ou d'un empilement de monocouches liées entre elles par des forces de van der Waals. Ces matériaux présentent d'excellentes propriétés mécaniques, électriques, optiques et thermiques, qui en font des matériaux de choix pour de nombreuses applications, dans des domaines aussi variés que les technologies de l'information, les technologies de la communication, la santé, l'énergie et le transport.

Les matériaux 2D sont jugés prometteurs également dans le domaine de la micro/nanoélectronique, dans la mesure où ils permettent d'obtenir des couches cristallines de très faible épaisseur, typiquement inférieure au nanomètre. Il est ainsi envisagé la réalisation de composants électroniques (comme des transistors ou des photodétecteurs) de dimensions nanométriques sur des substrats de diverses natures, en utilisant le matériau bidimensionnel comme un matériau semi-conducteur.

La croissance d'un matériau 2D est généralement réalisée à une température très élevée (800 °C -1200 °C), qui est souvent incompatible avec le substrat sur lequel on souhaite intégrer ce matériau bidimensionnel, appelé substrat cible ou substrat final. En effet, ce substrat cible peut déjà supporter des composants (ou parties de composant) qui seraient dégradés lors de la synthèse du matériau 2D. Pour pallier ce problème, on dissocie les étapes de croissance et d'intégration. On fait croître le matériau 2D sur un substrat de croissance adapté puis on transfère le matériau 2D depuis son substrat de croissance vers le substrat d'intérêt. La principale difficulté réside dans la conservation des propriétés intrinsèques du matériau 2D après transfert.

Le document [« Transfer of Large-scale two dimensional semiconductors: challenge and developments », Watson et al., 2D materials, 8, 2021, 032001] décrit plusieurs procédés de transfert connus.

Une première catégorie de procédés utilise une couche support (en polymère ou en métal) disposée sur le matériau 2D. Cette couche support offre un maintien mécanique du matériau 2D au cours du transfert, principalement entre le moment où le matériau 2D est détaché du substrat de croissance et le moment où il est placé sur le substrat cible. Cela permet de réduire les déformations du matériau 2D au cours du transfert.

Les documents [« Surface-energy-assisted perfect transfer of centimeter-scale monolayer and few-layer MoS2 films onto arbitrary substrates », Gurarslan et al., ACS Nano, 2014 Nov 25;8(11):11522-8] et [« Large-Area Transfer of 2D TMDCs Assisted by a Water-Soluble Layer for Potential Device Applications », Madan Sharma et al., ACS Oméga 2022, 7, 11731-11741] décrivent deux exemples de procédés de transfert utilisant une couche en polymère.

Les documents [« Layer-engineered atomic-scale spalling of 2D van der Waals crystals », Ji-Yun Moon et al., Matter, 5, 3935-3946, 2022] et [« Controlled crack propagation for atomic précision handling of wafer-scale two-dimensional materials », Jaewoo Shim et al., Science 362, 665-670, 2018] décrivent deux exemples de procédé de transfert utilisant une couche support en métal.

L'utilisation d'une couche support en métal plutôt qu'en polymère permet d'éviter de laisser des résidus de polymère sur le matériau 2D. Toutefois, des résidus de métal et des fissures peuvent être générés sur le matériau 2D.

Une deuxième catégorie de procédés de transfert n'utilise pas de couche support. Cela permet d'éviter tout résidu de polymère ou de métal sur le matériau 2D.

Le document [« Centimeter-scale Green Intégration of Layer-by-Layer 2D TMD vdW Heterostructures on Arbitrary Substrates by Water-Assisted Layer Transfer », Kim et al., Scientific reports, 9, 1641, 2019] décrit un procédé qui s'affranchit de la couche support.

Le matériau 2D disposé sur le substrat de croissance est plongé dans de l'eau. L'eau produit alors une délamination immédiate du matériau 2D qui se détache du substrat de croissance et vient flotter à la surface de l'eau. Il faut alors récupérer le matériau 2D, qui se présente alors sous la forme d'un film mince, puis le placer sur le substrat cible.

Le fait de laisser flotter, puis de manipuler sans soutien mécanique un film aussi mince que le matériau 2D occasionne sur celui-ci des plis et des trous. Ces défauts perdurent une fois le matériau 2D collé au substrat cible et contribuent à détériorer les performances du dispositif final. Ils sont, notamment, particulièrement préjudiciables lorsque des applications optiques et de photoluminescence sont envisagées.

De plus, la manipulation du matériau 2D dans l'eau (ou plus généralement dans tout type de liquide) n'est pas adaptée à un transfert de couches dont la superficie est supérieure à quelques centimètres carrés, ni à l'environnement salle-blanche de l'industrie microélectronique.

### RESUME DE L'INVENTION

Il existe donc un besoin d'améliorer les procédés existants pour transférer un matériau 2D sur un substrat cible donné.

En particulier, il existe un besoin d'un procédé d'élaboration et de transfert un matériau 2D qui n'engendre ni résidus de polymère et/ou de métal, ni de déformations mécaniques, au niveau du matériau 2D.

Selon l'invention, on tend à satisfaire ce besoin en prévoyant un procédé d'élaboration et de transfert d'un matériau bidimensionnel, comprenant les étapes suivantes :
- Croissance du matériau bidimensionnel sur une surface d'un substrat de croissance de sorte que le matériau bidimensionnel soit lié à la surface du substrat de croissance par des forces de van der Waals, la surface du substrat de croissance ayant un premier angle de contact avec une goutte d'un liquide ;
- Fourniture d'un substrat cible, le substrat cible présentant une surface ayant un deuxième angle de contact avec une goutte du liquide, le deuxième angle de contact étant strictement supérieur au premier angle de contact ;
- Assemblage du substrat de croissance et du substrat cible par collage direct entre le matériau bidimensionnel et la surface du substrat cible ; et
- Rupture de l'interface entre le substrat de croissance et le matériau bidimensionnel, en appliquant une sollicitation mécanique à l'assemblage du substrat de croissance et du substrat cible pour générer et propager un front de fissure à l'interface entre le substrat de croissance et le matériau bidimensionnel, et en plaçant l'assemblage du substrat de croissance et du substrat cible dans un environnement tel qu'un front du liquide se forme à l'interface entre le substrat de croissance et le matériau bidimensionnel, la sollicitation mécanique étant configurée pour que le front du fissure soit mouillé par le liquide.

Ainsi, la surface du substrat de croissance et la sollicitation mécanique sont configurées pour que le front de fissure soit mouillé par le liquide tout au long de la propagation de la fissure. Cela permet de désolidariser le matériau bidimensionnel et substrat de croissance par rupture adhésive, puisque la fissure est confinée dans l'interface entre le substrat de croissance et le matériau bidimensionnel.

De plus, prévoir une capacité de mouillage (vis-à-vis du liquide) de la surface du substrat cible moindre que celle de la surface du substrat de croissance permet d'obtenir une interface entre le substrat de croissance et le matériau bidimensionnel affaiblie. La rupture adhésive se déroulera à cette interface et non pas à l'interface entre le substrat cible et le matériau bidimensionnel, qui est donc plus résistante à une telle rupture adhésive.

Cela permet de relâcher les contraintes lors de la mise en oeuvre de la sollicitation mécanique, et donc de séparer le substrat de croissance du substrat cible (le matériau bidimensionnel étant collé sur ce substrat cible) de manière aisée, sans requérir un équipement complexe, par exemple en réalisant une séparation simple par insertion de coin.

La différence d'angle de contact, et donc de mouillabilité, des surfaces du substrat cible et du substrat de croissance permet en outre d'obtenir un procédé adapté à une grande variété de combinaisons de substrats et de matériaux bidimensionnels par rapport aux procédés basés sur des propriétés intrinsèques des substrats et/ou du matériau bidimensionnel. En effet, le caractère mouillable des substrats n'est pas nécessairement une propriété intrinsèque du substrat. Il peut être aisément acquis (des substrats peu mouillants peuvent être rendus très mouillants ou vice-versa) à l'aide, par exemple, de traitements de surface physico-chimiques.

De plus, grâce au collage direct, le substrat cible joue le rôle de couche support du matériau bidimensionnel. Cela permet de conserver un maintien mécanique du matériau bidimensionnel au cours du transfert, tout en s'affranchissant des étapes de formation et de retrait d'une couche support (parce qu'elles ne sont plus nécessaires).

L'absence de la couche support permet en outre d'éviter tout résidu de polymère ou métal (ceux-ci étant liés à la couche support), ni n'occasionne de détérioration car aucun matériau n'est déposé sur le matériau 2D.

Le collage direct, de même que l'étape de fracture, sont en outre compatibles avec l'industrie microélectronique et applicables aux couches de matériau 2D de grandes superficies. Le collage direct est en effet couramment employé à grande échelle et sur des plaquettes de 300 mm pour transférer des couches minces semiconductrices.

Outre les caractéristiques qui viennent d'être évoquées dans les paragraphes précédents, le procédé d'élaboration et de transfert selon l'invention peut présenter une ou plusieurs caractéristiques complémentaires parmi les suivantes, considérées individuellement ou selon toutes les combinaisons techniquement possibles :
- L'écart entre le premier et le deuxième angle de contact est strictement supérieur à 10°, de préférence supérieur à 30°, de préférence supérieur à 50°.
- La fourniture du substrat cible comprend un traitement de la surface du substrat cible de manière à augmenter le deuxième angle de contact.
- Le procédé comprend, avant l'étape de croissance du matériau bidimensionnel, une étape de traitement de la surface du substrat de croissance de manière à réduire le premier angle de contact.
- La sollicitation mécanique est configurée pour permettre une avancée du front de fissure à une vitesse inférieure ou égale à 100 µm/s, de préférence inférieure ou égale à 10 µm/s, de préférence encore inférieure ou égale à 1 µm/s.
- La sollicitation mécanique est exercée par une lame d'épaisseur inférieure ou égale à 500 µm, de préférence d'épaisseur inférieure ou égale à 300 µm, de préférence encore inférieure ou égale à 100 µm.
- L'épaisseur de la lame est inférieure ou égale à 100 µm, et la lame est insérée à une première vitesse pour initier la fissure et à une deuxième vitesse pour propager la fissure dans l'interface entre le substrat de croissance et le matériau bidimensionnel, la première vitesse étant inférieure ou égale à 1 µm/s, et la deuxième vitesse étant supérieure à la première vitesse et inférieure ou égale à 100 µm/s.
- Lors de l'étape de rupture de l'interface entre le substrat de croissance et le matériau bidimensionnel, l'assemblage du substrat de croissance et du substrat cible est placé dans le liquide.
- Le liquide est de l'eau déionisée ou une solution ionique.
- Lors de l'étape de rupture de l'interface entre le substrat de croissance et le matériau bidimensionnel, l'assemblage du substrat de croissance et du substrat cible est placé dans un milieu gazeux comprenant de la vapeur d'eau déionisée ou de la vapeur d'une solution ionique.
- Le matériau bidimensionnel est préférentiellement du graphène, du nitrure de bore à structure cristalline hexagonale (h-BN) ou un dichalcogénure de métal de transition.
- La surface du substrat de croissance et la surface du substrat cible sont chacune formée d'un matériau choisi parmi le silicium (Si), le germanium (Ge), le dioxyde de silicium (SiO₂), le carbure de silicium (SiC), le phosphure d'indium (InP), l'arséniure de gallium (AsGa) et le saphir (Al₂O₃).
- La surface du substrat de croissance est formée d'une couche de base de silicium ou de germanium recouverte ou non d'une couche superficielle d'un matériau choisi parmi les matériaux suivants : aluminium (AI), nitrure de silicium (Si₃N₄), cuivre (Cu), titane (Ti), alumine (Al₂O₃), dioxyde de silicium (SiO₂), oxyde d'hafnium (HfO₂), nickel (Ni), graphène.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- les figures 1A à 1C représentent schématiquement des étapes d'un procédé d'élaboration et de transfert de matériau 2D selon l'invention ;
- la figure 2 représente, de manière schématique, d'une part, une goutte de liquide déposée sur la surface d'un substrat de croissance conforme à l'invention et, d'autre part, une goutte déposée sur la surface d'un substrat cible conforme à l'invention ;
- la figure 3 représente, pour différents substrats cible, des mesures de l'angle de contact de goutte de chaque surface du substrat cible en fonction d'une concentration en CF₄ et SF₆, obtenues après un traitement de ces surfaces ;
- la figure 4 est une photographie en vue de dessus du substrat de croissance obtenu à l'issue d'un premier exemple de mise en oeuvre du procédé représenté sur les figures 1A à 1C, le matériau bidimensionnel non transféré apparait en gris foncé ;
- la figure 5 est une photographie en vue de dessus du substrat de croissance obtenu à l'issue d'un deuxième exemple de mise en oeuvre du procédé représenté sur les figures 1A à 1C, le matériau bidimensionnel non transféré apparait en gris foncé.

Pour plus de clarté, les éléments identiques ou similaires sont repérés par des signes de référence identiques sur l'ensemble des figures.

### DESCRIPTION DETAILLEE

La présente invention vise à améliorer les procédés de transfert d'un matériau bidimensionnel sur un substrat d'intérêt, appelé aussi substrat cible.

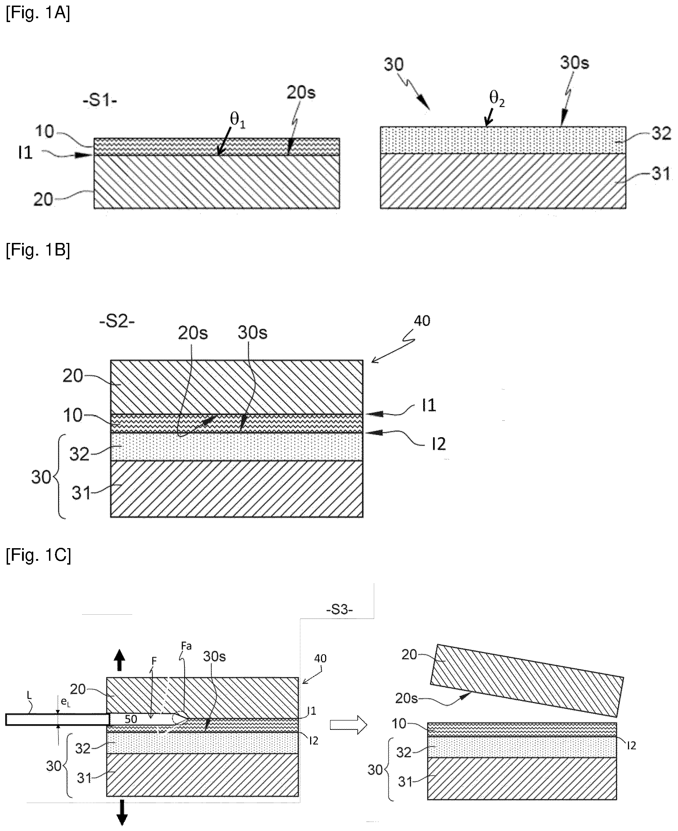

Les figures 1A à 1C illustrent des étapes S1 à S3 d'un procédé d'élaboration et de transfert d'un matériau bidimensionnel 10. Selon ce procédé, le matériau bidimensionnel 10 est transféré d'un substrat de croissance 20 à un substrat support 30, noté par la suite « substrat cible 30 ».

Un matériau bidimensionnel (2D) désigne un matériau composé d'un feuillet (aussi appelé monocouche) mono-atomique ou mono-moléculaire ou d'un empilement de N feuillets mono-atomiques ou mono-moléculaires identiques (N étant un entier naturel supérieur ou égal à 2). Par feuillets identiques, on entend des feuillets présentant des atomes ou molécules de même nature et ordonnés de la même façon. Le matériau 2D est dit « monocouche » lorsqu'il ne comprend qu'un seul feuillet et « multicouche » lorsqu'il comprend plusieurs feuillets. Au sein de chaque feuillet, les atomes (ou molécules) sont liés (liées) entre eux (elles) par des liaisons covalentes. Les différents feuillets d'un matériau 2D multicouche sont liés entre eux par des forces de van der Waals.

On considère ici que le matériau possède des propriétés « 2D » lorsqu'il comprend moins de dix feuillets mono-atomiques ou mono-moléculaires (N<10, par exemple N=3). Au-delà, ses propriétés sont celles d'un matériau massif.

L'étape S1 représentée par la figure 1A comprend la fourniture du substrat de croissance 20, la croissance du matériau 2D 10 à partir d'une surface 20s du substrat de croissance 20, ainsi que la fourniture du substrat cible 30.

A l'échelle atomique, le matériau 2D 10 est ainsi lié (ou adhère) à la surface 20s du substrat de croissance 20 par des forces de van der Waals. L'interface entre le matériau 2D et le substrat de croissance 20 est notée « I1 » sur les figures.

Le matériau 2D 10 peut être du graphène, du nitrure de bore à structure cristalline hexagonale (h-BN) ou un dichalcogénure de métal de transition, comme le disulfure de tungstène (WS₂), le disulfure de molybdène (MoS₂), le diséléniure de molybdène (MoSe₂) ou le diséléniure de tungstène (WSe₂).

Le substrat de croissance 20 est une plaquette (« wafer »).

Le substrat de croissance 20 présente une surface libre 20s (noté plus simplement « surface 20s du substrat de croissance » par la suite) servant de support à la croissance du matériau 2D 10. De préférence, la surface libre 20s du substrat de croissance 20 correspond à l'une de ses faces principales.

Le substrat de croissance 20 peut être formé d'un unique matériau, comme cela est représenté par la figure 1A. Le substrat de croissance 20 peut ainsi être formé d'un matériau choisi parmi les matériau suivants : silicium (Si), dioxyde de silicium (SiO₂), saphir (Al₂O₃), carbure de silicium (SiC), germanium (Ge), Arséniure de gallium (AsGa), phosphure d'indium (InP). Alternativement, il peut comprendre une couche de support en un premier matériau, par exemple en silicium, et une couche superficielle en un deuxième matériau distinct du premier matériau. La couche superficielle est disposée sur la couche de support 11 et forme la surface 20s du substrat de croissance. Le deuxième matériau peut être choisi parmi les matériaux suivants : aluminium (AI), cuivre (Cu), titane (Ti), dioxyde de silicium (SiO₂), nitrure de silicium (Si₃N₄), alumine (Al₂O₃), nickel (Ni), graphène.

Le diamètre du substrat de croissance 20 peut être supérieur à 200 mm, par exemple 300 mm.

A titre d'exemple, le substrat de croissance 20 peut être une plaquette de silicium de 300 mm de diamètre, présentant une épaisseur généralement comprise entre 300 µm et 1000 µm, préférentiellement 775 µm et une rigidité mécanique caractérisée par un module d'Young de l'ordre de 129 GPa.

La surface 20s du substrat de croissance 20 présente un caractère de mouillabilité vis-à-vis d'un liquide 50 suffisant pour que le liquide 50 s'étale sur cette surface 20s.

Dans la description qui suit, le terme « mouillage » regroupe de manière générale tous les phénomènes (diffusion superficielle, transferts de masse à l'interface, etc.) qui interviennent lorsqu'un liquide est mis en contact avec une surface solide. Ces phénomènes dépendent du couple constitué par la nature du liquide et le matériau de la surface solide.

En pratique, le caractère mouillable d'une surface solide est mesuré par l'angle de mouillage, aussi appelé angle de contact de goutte, ou encore, plus simplement angle de contact, que fait une goutte du liquide sur la surface solide.

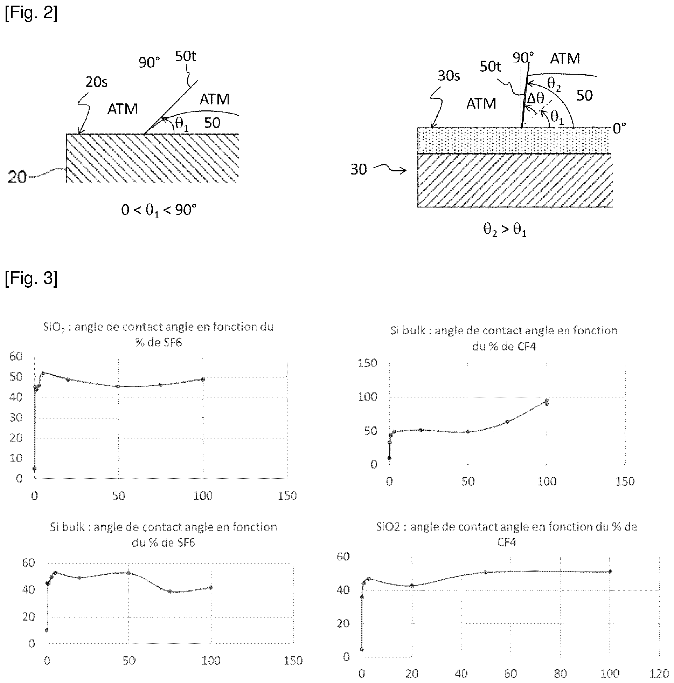

Cet angle de contact est représenté sur la figure 2 pour le couple {surface 20s du substrat de croissance 20 ; liquide 50}, où il est noté « premier angle de contact *θ*₁ ».

Comme le montre la figure 2, le premier angle de contact *θ*₁ est défini entre la surface 20s solide et la ligne triple 50t (interface triple entre le milieu extérieur gazeux ou atmosphère ATM, le liquide 50 et la surface 20s solide) et est strictement inférieur à 90°. Ainsi, le liquide 50 s'étale sur la surface 20s du substrat. On note, que dans la suite de la description, on considère que le milieu extérieur gazeux ATM est de l'air.

De préférence, le premier angle de contact *θ*₁ est inférieur à 30°. Cela permet un meilleur mouillage (un meilleur étalement) du liquide 50 sur la surface 20s du substrat de croissance 20.

Le premier angle de contact *θ*₁ peut, aussi, être nul. Dans cette configuration, le mouillage est dit « total », c'est-à-dire qu'une goutte du liquide 50 s'étale complètement pour former un film d'épaisseur constante sur la surface 20s du substrat de croissance. En pratique, on considère qu'il y a mouillage total lorsque l'on mesure un angle de contact inférieure à 5°.

Le liquide est avantageusement pur et non volatil, de tension superficielle faible, par exemple inférieure à 80 mN/m. Le liquide est préférentiellement choisi parmi les liquides suivants : de l'eau ou une solution ionique.

Par exemple, le liquide peut être de l'eau déionisée. On note que lorsque le liquide est à base d'eau, on utilise généralement les termes « hydrophobe » et « hydrophile » pour désigner, respectivement, une surface plutôt non mouillable et une surface plutôt mouillable.

Dans un autre exemple, le liquide peut être une solution à base d'hydroxyde potassium (ou KOH). Encore dans un autre exemple, le liquide peut être à base d'hydroxyde de sodium (ou NaOH) en solution dans de l'eau.

De préférence, le liquide 50 est de l'eau déionisée et filtrée pour éviter toute contamination particulaire.

La technique de croissance employée pour faire croître le matériau 2D 10 sur la surface 20s du substrat de croissance 20 peut être le dépôt de couches atomiques (ou ALD, pour « atomic layer déposition » en anglais), l'épitaxie en phase vapeur (ou VPE, pour « vapor phase epitaxy »), le dépôt chimique en phase vapeur ( ou CVD pour « Chemical Vapor Déposition ») à partir de précurseurs solides ou gaz, ou à partir de précurseur métalorganiques (ou MOCVD, pour « métal organic chemical vapor déposition »), le dépôt chimique en phase vapeur assisté par plasma (ou PECVD, pour « plasma enhanced chemical vapor déposition ») ou l'épitaxie par jets moléculaires (ou MBE, pour « Molecular Beam Epitaxy »). Elle dépend du matériau 2D à faire croître. La technique employée génère des forces de van der Waals entre le matériau 2D 10 et la surface 20s du substrat de croissance 20.

Le substrat cible 30 se présente également sous la forme d'une plaquette.

Le diamètre du substrat cible 30 peut être supérieur à 200 mm, par exemple 300 mm.

Le substrat cible 30 peut comprendre une couche support 31, par exemple en silicium ou germanium, et une couche superficielle 32 disposée sur la couche support 31, comme représenté par la figure 1A.

La couche superficielle 31 est formée d'un matériau choisi parmi les (mais non limité aux) matériaux suivants : le silicium (Si), le germanium (Ge), le dioxyde de silicium (SiO₂), le nitrure de silicium (Si₃N₄) ou le saphir (Al₂O₃).

Le substrat cible 30 peut être destiné à la fabrication de circuits intégrés et comporter des composants électroniques ou des parties de composants électroniques, typiquement dans la couche de support 31.

Alternativement, le substrat cible 30 est formé d'un seul matériau, celui-ci étant alors choisi parmi les matériaux suivants : le silicium (Si), le germanium (Ge), le carbure de silicium (SiC), l'aséniure de gallium (AsGa) ou le saphir (Al₂O₃).

La fourniture du substrat cible 30 peut ainsi comprendre une sous-étape de dépôt de la couche superficielle 32 sur la couche de support 31.

La couche superficielle 32 du substrat cible 30 présente une surface libre formant la surface 30s du substrat cible 30.

De préférence, la surface 30s du substrat cible correspond à l'une de ses faces principales.

La surface 30s du substrat cible 30 présente un angle de contact *θ*₂ entre une goutte du liquide 50 et la surface 30s (noté « deuxième angle de contact *θ*₂ » par la suite) strictement supérieur au premier angle de contact *θ*₁ (de la surface 20s du substrat de croissance 20). Ce deuxième angle de contact *θ*₂ , ainsi que l'écart Δ*θ* entre le premier et le deuxième angle de contact *θ*₁, *θ*₂ sont représentés par la figure 2.

Ainsi, le liquide 50 s'étale et s'écoule moins bien sur la surface 30s du substrat cible que sur celle du substrat de croissance 20. Le deuxième angle de contact *θ*₂ se rapproche, atteint ou dépasse la valeur de 90° qui correspond au seuil de non-mouillage.

Dit autrement, en prévoyant ainsi un deuxième angle de contact *θ*₂ plus grand que le premier angle de contact *θ*₁, le liquide 50 est plutôt mouillant sur la surface 20s du substrat de croissance 20, tandis qu'il est plutôt non-mouillant sur la surface 30s du substrat cible 30.

Plus l'écart Δ*θ* entre le premier et le deuxième angle de contact *θ*₁, *θ*₂ est grand, plus le régime de mouillage entre les deux surfaces 20s et 30s est différent. En l'occurrence, plus cet écart Δ*θ* est grand, plus le liquide 50 va être mouillant sur la surface 20s du substrat de croissance et peu mouillant (jusqu'à être non mouillant) sur la surface 30s du substrat cible 30.

De préférence, l'écart Δ*θ* entre le premier et le deuxième angle de contact est supérieur de 10°, de préférence supérieur à 30°.

Plus avantageusement encore, le deuxième angle de contact est supérieur de plus de 50° par rapport au premier angle de contact. Cela permet d'obtenir une surface 30s du substrat cible qui présente un caractère totalement non-mouillant. En d'autres termes, cela permet de s'assurer que le liquide ne s'étale pas sur la surface 30s du substrat cible 30.

Le substrat de croissance 20 et/ou le substrat cible 30 peuvent être traités en surface afin d'obtenir l'écart Δ*θ* spécifié (souhaité) entre le premier et le deuxième angle de contact.

Ce type de traitement de surface permet de modifier les propriétés physico-chimiques de mouillage et donc l'angle de contact des substrats (précisément de leurs surfaces). Par exemple, un substrat en silicium ou en germanium, naturellement mouillable par la plupart des liquides (il présente une surface de haute énergie) peut être rendu peu mouillable (ou hydrophobe, lorsque le liquide est de l'eau ou de l'eau déionisée) par ces traitements. Le substrat de croissance peut aussi être traité pour être rendu encore plus mouillable : un substrat de croissance en silicium naturellement hydrophile peut, en effet, être rendu encore plus hydrophile (ou super hydrophile).

Cela permet d'utiliser des substrats de croissance et cible 20, 30 de même nature. A titre d'exemple, le substrat de croissance 20 et le substrat cible 30 peuvent être tous deux des plaquettes de silicium ou germanium. Ils peuvent même provenir d'un même substrat source en silicium ou germanium séparé en deux (chaque partie fourni un substrat).

Cela procure en outre l'avantage d'augmenter le choix des matériaux possibles pour chaque substrat (de croissance, cible), puisque leur caractère de mouillabilité (ou leur angle de contact) peut être acquis a posteriori, et ne constitue pas une propriété intrinsèque du/des substrat(s) Le procédé selon l'invention est ainsi polyvalent, dans le sens où il est capable de s'adapter à différents substrats.

La fourniture du substrat cible 30 peut ainsi comprendre un traitement de surface du substrat cible ayant pour but d'augmenter la valeur du deuxième angle de contact, c'est-à-dire de réduire le caractère mouillable de sa surface 30s.

Ainsi, avant la mise en oeuvre de ce traitement de surface, le deuxième angle de contact *θ*₂ de la surface 30s du substrat cible 30 présente une valeur initiale, et il présente une valeur finale après l'achèvement de ce traitement de surface. La valeur finale (post-traitement) du deuxième angle de contact *θ*₂ est supérieure à la valeur initiale du deuxième angle de contact *θ*₂ et est strictement supérieure au premier angle de contact *θ*₁.

Ce traitement de surface (appelée aussi fonctionnalisation de la surface) est par exemple utile lorsque le substrat cible est en silicium, en germanium ou en dioxyde de silicium. En effet, comme détaillé précédemment, le substrat cible 30 présente alors, à l'état naturel, une valeur initiale du deuxième angle de contact basse, qui le rend mouillable vis-à-vis de la plupart des liquides aqueux.

Plusieurs procédés peuvent être alors mis en oeuvre. Chaque procédé est adapté pour un ou plusieurs couples matériau de la surface 30s du substrat cible et liquide.

Lorsque le substrat cible 30 est formé de silicium ou de germanium et que le liquide est de l'eau ou de l'eau déionisée, une première catégorie de procédés consiste à recouvrir la surface 30s du substrat cible d'un tapis hydrogéné, hydrophobe. Cela permet d'obtenir une surface 30s du substrat cible ayant un deuxième angle de contact compris entre 70° et 80°.

Selon l'un des procédés de cette première catégorie, le traitement de surface comprend une opération de désoxydation consistant à retirer la fine couche d'oxyde présente naturellement (à l'air libre) en surface du substrat cible 30 (aussi appelée oxyde natif), puis une opération de passivation de la surface 30s du substrat cible par des atomes d'hydrogène.

Cette opération de passivation de la surface 30s peut se faire par une trempe du substrat cible 30 dans un solution à base de fluorure d'hydrogène (HF). La concentration en HF de cette solution est, en concentration massique, supérieure à 0,01%, de préférence supérieure à 1%, de préférence encore supérieure à 48%.

Parmi les concentrations spécifiées, les plus élevées (1%, 48%) sont particulièrement avantageuses. En effet, elles modifient moins la rugosité du matériau, qui reste ainsi très faible, de l'ordre de 2 angströms (taille résiduelle quadratique des aspérités). Cette conservation de la très faible rugosité de la surface 30s du substrat cible 30 permet d'améliorer la qualité du collage réalisé lors de l'étape S2.

Alternativement, l'opération de passivation peut se faire à base de fluorure d'hydrogène sous forme vapeur.

Alternativement, l'opération de passivation peut consister en un traitement sous vide à haute température, supérieure à 700°C ou, de préférence, supérieure à 800°C. Le traitement est alors réalisé sous atmosphère réductrice contenant de l'hydrogène. Ces traitements à haute température ont pour effet de réduire la rugosité de la surface 30s du substrat cible obtenue après le traitement, ce qui est favorable à une bonne qualité de collage lors de l'étape S2.

Selon un autre procédé appartenant à la première catégorie de procédés de traitement, le traitement de surface comprend une opération d'épitaxie de silicium ou de germanium sur la surface 30s du substrat cible, de manière à obtenir une couche superficielle de silicium ou de germanium d'épaisseur supérieure à 10 nm et même supérieure à 50 nm. En outre, avant l'achèvement de cette opération d'épitaxie, le substrat cible 30 est placé sous une atmosphère réductrice contenant de l'hydrogène.

Une deuxième catégorie de procédés consiste à recouvrir la surface 30s du substrat cible d'un tapis fluoré, également hydrophobe. Cela permet d'obtenir une surface 30s du substrat cible ayant un deuxième angle de contact supérieur à 40°. Cette deuxième catégorie de procédés offre l'avantage d'être compatibles avec les substrats cibles en dioxyde de silicium (en plus de ceux en silicium ou germanium). Les procédés de cette deuxième catégorie utilisent un plasma fluoré, par exemple un plasma d'azote comprenant du tétra-fluorure de carbone (CF₄) ou d'hexafluorure de soufre (SF₆).

La figure 3 représente les angles de contacts mesurés sur des substrats cibles de silicium (notés « Si bulk » sur la figure) et des substrats cibles de dioxyde de silicium (notés « SiO₂ » sur la figure) en fonction du pourcentage de SF₆ ou de CF₄ mélangé à de l'azote.

Comme le montre la figure 3, lorsque le substrat cible 30 est formé de SiO₂, le deuxième angle de contact *θ*₂ varie peu en fonction de la concentration en SF₆ ou de la concentration en CF₄, puisqu'il est compris entre 45° et 50°. Le deuxième angle de contact *θ*₂ varie plus largement selon la concentration en SF₆ ou en CF₄ lorsque le substrat cible est en silicium, mais des deuxièmes angles de contact supérieurs à 40° peuvent être obtenus. Ainsi, pour une concentration en SF₆ comprise entre 10% et 50% le deuxième angle de contact est supérieur à 50°. De plus, pour une concentration en CF₄ supérieure à 70%, le deuxième angle de contact est supérieur ou égal à 60°.

Une troisième catégorie de procédés consiste à déposer une couche superficielle ayant des angles de contact élevés sur la surface 30s du substrat cible 30. Le substrat cible 30 ainsi traité (donc comprenant cette couche superficielle produite par le traitement de surface) constitue le substrat cible 30 utilisé lors de l'étape suivante S2.

Le document « Silane Modification of Glass and Silica Surfaces to Obtain Equally Oil-Wet Surfaces in Glass-Covered Silicon Micromode Applications" de Grate et al., Water Resources Research, 2013, 49 (8), 4724, décrit un exemple de procédé appartenant à cette troisième catégorie.

Dans cet exemple, le traitement de surface comprend la formation, sur un substrat cible 30 de silicium ou de dioxyde de silicium, d'une couche superhydrophobe à base de hexamethyldisilazane (ou HDMS). Le terme « superhydrophobe » est employé en raison de l'angle de contact très élevé, typiquement égal à ou proche de 100°, qui obtenu en surface, une fois le traitement achevé. Le document "Préparation and Characterization of Superhydrophobic Surfaces Based on Hexamethyldisilazane-Modified Nanoporous Alumina." de Tasaltin et al., Nanoscale Res Lett 2011, 6 (1), 487 décrit qu'une telle couche HDMS peut aussi être formée sur un substrat en alumine.

Le document « Delivering Octadecylphosphonic Acid Self-Assembled Monolayers on a Si Wafer and Other Oxide Surfaces. » de Nie et al., J. Phys. Chem. B 2006, 110 (42), 21101-21108, décrit un autre exemple de procédé appartenant à la troisième catégorie. Selon ce procédé, le traitement de surface peut comporter une opération de formation de monocouches auto-assemblées (aussi appelées SAM pour « Self-Assembled Monolayer » en anglais) d'acide octadécylphosphonique (ou OPA) sur la surface 30s du substrat cible 30, à l'aide d'un milieu non polaire ayant une constante diélectrique d'environ 4 (par exemple, trichloréthylène). Ce procédé offre l'avantage d'être compatible avec de nombreuses surfaces d'oxyde. Il permet aussi d'obtenir une rugosité résiduelle finale plus faible que celle obtenue lorsqu'une couche de HDMS est formée.

Comme mentionné précédemment, le substrat de croissance 20 peut aussi subir un traitement de surface visant à abaisser le premier angle de contact *θ*₁. Autrement dit, la surface 20s du substrat de croissance 20 présente alors une valeur initiale avant la mise en oeuvre de ce traitement de surface, et une valeur finale après l'achèvement de ce traitement de surface. La valeur finale (post-traitement) du premier angle de contact est inférieure à la valeur initiale du premier angle de contact et strictement inférieure au deuxième angle de contact.

A l'étape S2 de la figure 1B, le substrat de croissance 20 (recouvert du matériau 2D 10) et le substrat cible 30 sont assemblés par collage direct (autrement dit, sans apport de matière adhésive ou métallique) entre le matériau 2D 10 et la surface 30s du substrat cible 30. La surface libre du matériau 2D 10 est ainsi mise en contact (direct) avec la surface 30s du substrat cible 30.

Le collage S2 est généralement mis en oeuvre à température ambiante et pression ambiante. Il est toutefois possible de le mettre en oeuvre sous vide et à température ambiante. Alternativement, le collage S2 peut être mis en oeuvre sous une température comprise entre 25°C et 400°C par exemple égale à 100°C.

Le matériau 2D 10 se retrouve alors lié par des forces de van der Waals à la surface 30s du substrat cible 30, constituée ici par le matériau de la couche superficielle 32 (cf. Fig.1B). L'interface entre le matériau 2D et le substrat cible 30 est notée « I2 » sur la figure 1B.

Les surfaces de collage, à savoir la surface libre du matériau 2D 10 et la surface 30s du substrat cible 30, présentent avantageusement une rugosité de surface inférieure à 0,5 nm et même inférieure à 0,2 nm. Cette valeur de rugosité, ainsi que toutes celles données par la suite, sont exprimées en valeur moyenne quadratique. La rugosité moyenne quadratique (notée Rq) est déterminée par une analyse statistique d'une image de microscope à force atomique, en prenant comme échantillon une surface de 1x1 µm².

Les techniques de croissance des matériaux 2D permettent d'obtenir une rugosité de surface inférieure à 0,5 nm et même inférieure à 0,2 nm. En revanche, le substrat cible 30 peut avoir subi, entre l'étape de fourniture S1 du substrat cible 30 et l'étape S2 d'assemblage par collage, une étape de polissage (par exemple par planarisation mécano-chimique ou CMP) de sa surface de collage 30s de manière à obtenir une valeur de rugosité de surface inférieure à 0,5 nm et même inférieure à 0,2 nm.

A l'issue de l'étape S2, l'assemblage 40 représenté par la figure 1B est obtenu. Comme le montre la figure 1B, cet assemblage 40 est un monobloc multi-matériaux puisqu'il comprend successivement, du bas vers le haut sur la figure, le substrat cible 30, l'interface I2, le matériau 2D 10, l'interface I1 et le substrat de croissance 20.

Les interfaces bi-matériaux I1, I2 ont une épaisseur (mesurée perpendiculairement au plan de l'assemblage 40) inférieure ou égale à 1 nm en valeur moyenne.

Enfin, l'étape S3 de la figure 1C (en particulier la figure de droite de la figure 1C) consiste à séparer le substrat de croissance 20 et le substrat cible 30 de manière qu'au moins une partie du matériau 2D 10 se détache du substrat de croissance 20 et reste collée au substrat cible 30.

Comme le montre la figure 1C (en particulier la figure de gauche), la séparation du substrat de croissance 20 et du substrat cible 30 est accomplie en rompant l'interface I1 entre le substrat de croissance 20 et le matériau 2D 10 par propagation, dans cette interface I1, d'une fissure interfaciale F mouillée jusqu'à son front Fa par le liquide 50.

Une façon pour mouiller le front Fa de fissure tout au long de l'avancée de la fissure F consiste à déplacer le front Fa de fissure à une vitesse suffisamment lente pour que le liquide 50 s'étale jusqu'à ce front Fa.

Le fait de maintenir le front Fa de fissure mouillé par le liquide 50 permet, notamment, de s'assurer que la fissure F soit contrainte dans l'interface I1. En d'autres termes, cela permet que la rupture soit une rupture de type adhésive, c'est-à-dire que la rupture se produise au niveau de l'interface I1, le matériau 2D étant retenu sur la surface 30s du substrat cible 30 et le substrat de croissance étant désolidarisé de l'assemblage 40. Cela permet de transférer le matériau 2D avec succès.

De plus, cela permet d'entrainer le liquide 50 (celui-ci formant un film) sur toute la surface 20s du substrat de croissance 20, même lorsque celui-ci est de grande superficie (diamètre de 200 mm, voire 300 mm). On rappelle que, contrairement aux solutions de l'art antérieur, le liquide 50 ne peut ici s'infiltrer naturellement sur la surface 20s du substrat de croissance, du fait de la rigidité du substrat cible et de sa superficie.

En l'occurrence, grâce au liquide 50 qui mouille la fissure F jusqu'à son front Fa, le substrat de croissance et le matériau 2D sont interposés par ce film de liquide 50 et donc désolidarisés.

Le mouillage du front de fissure Fa par le liquide 50 contribue à diminuer l'énergie d'interface entre le matériau 2D 10 et le substrat de croissance 20, facilitant ainsi la propagation de la fissure F, qui peut alors se développer plus facilement en une fissure interfaciale s'étendant sur quasiment la totalité de l'interface I1.

La séparation S3 entre le substrat de croissance 20 et le matériau 2D peut notamment être accomplie de la manière décrite ci-après.

L'assemblage 40 est placé dans un environnement extérieur tel qu'un front du liquide 50 se forme au contact de l'assemblage 40 (et, par conséquent au front de fissure Fa de l'interface 11).

Cet environnement extérieur peut être un milieu liquide constitué par le liquide 50 lui-même. Dans ce cas, l'assemblage est immergé dans le liquide 50.

Alternativement, l'environnement extérieur peut être une atmosphère gazeuse comprenant en excès le liquide sous forme vapeur. Ainsi, le liquide sous forme vapeur se condense au contact de l'assemblage 40. Par exemple, l'environnement peut être de l'air avec 80% ou plus d'humidité (de vapeur d'eau).

Afin d'initier et de propager la fissure interfaciale, une sollicitation mécanique est appliquée sur l'assemblage 40, à partir de sites d'amorçage fournis par l'assemblage 40.

De préférence, ces sites d'amorçage se situent sur la surface extérieure (périphérique) du matériau 2D 10 de l'assemblage 40.

En pratique, une lame L, un coin (ou pointe) ou un fil peuvent être insérés entre le substrat de croissance 20 et le substrat cible 30, manuellement ou au moyen d'une machine. Alternativement, une force peut être exercée sur l'un au moins des substrats (ou plaquettes). Naturellement, d'autres moyens de contraintes mécaniques peuvent être utilisés. Par exemple, il est possible de réaliser une traction au moyen de mors collés sur les faces arrière des substrats (de croissance, cible) 20,30, à l'endroit de la première sollicitation mécanique. Il est possible de n'avoir qu'un mors en clampant (pinçant) le substrat de croissance ou le substrat cible sur un support, par exemple avec du vide. Il est possible de remplacer le ou les mors par des anneaux qui utilisent les chanfreins des substrats de croissance et cible 20,30 pour exercer une traction de la manière décrite dans le document US9583374B2.

Dans la description qui suit, on considère que le moyen de contrainte utilisé pour mettre en oeuvre la première sollicitation mécanique est une lame L telle que celle représentée par la figure 1C. Cependant, ses enseignements sont également valables pour les autres moyens de contraintes mécaniques, notamment le coin et le fil.

La sollicitation mécanique peut être décomposée en deux sollicitations mécaniques successives.

Dans un premier temps, une première sollicitation mécanique produit un décollement initial du matériau 2D par rapport au substrat de croissance 20.

Cette première sollicitation mécanique est assez délicate car lors de l'insertion du coin, ou de la lame, la vitesse de fissuration peut rapidement dépasser 100 µm/s. En effet, le coin, ou la lame, se trouve très proche du front de fissure Fa. Il est ainsi préférable, pour réaliser la première sollicitation mécanique, d'utiliser des moyens qui permettent d'appliquer une traction sur l'un et/ou l'autre des substrats (de croissance, cible). L'utilisation d'un anneau dans le chanfrein est par exemple bien adaptée.

La première sollicitation mécanique peut néanmoins produire, de manière non souhaitée, une fissure dans l'interface I2 entre le substrat cible 30 et le matériau 2D 10. Cette éventuelle présence d'une fissure dans l'interface I2 n'est toutefois pas problématique, pour les raisons données ci-après.

Du fait de l'écart entre le premier et le deuxième angle de contact, le liquide 50 est mouillant pour la surface 20s du substrat de croissance à l'interface I1 de l'assemblage, mais peu ou pas mouillant pour la surface 30s du substrat cible à l'interface I2. En conséquence, le liquide 50 issu de l'environnement extérieur de l'assemblage 40 s'infiltre sur les bords de cette fissure ou à travers quelques défauts de structures du matériaux 2D pour retourner et mouiller préférentiellement l'interface I1 entre le matériau 2D 10 et le substrat de croissance 20. Ceci permet alors de bifurquer la fissure à la bonne interface (l'interface I1) quand la vitesse d'ouverture repasse en dessous de 100 µm/s.

En revanche, ce liquide 50 ne s'infiltre pas sur le côté ou à travers un quelconque défaut du matériau 2D 10 pour aller vers l'interface I2 entre le matériau 2D 10 et le substrat cible 30 grâce à l'absence de mouillage sur la surface 30s du substrat cible 30. Aucun processus pouvant provoquer une bifurcation de la fissure n'est donc activé dans cette interface I2. En conséquence, cette interface I2 reste intègre et le matériau 2D reste collé au substrat cible 30.

Ainsi, grâce aux propriétés de mouillage spécifiées pour les surfaces 20s, 30s des substrats de croissance et cible, la séparation du substrat de croissance et du substrat cible est réalisée de manière sélective (car elle concerne l'interface 11) et de manière simple : immerger l'assemblage 40 dans le liquide 50 est simple à mettre en oeuvre et la sollicitation mécanique ne nécessite pas d'équipement de précision nanométrique (à l'échelle de l'épaisseur de l'interface 11).

L'épaisseur e_{L} de la lame L est choisie pour que le décollement initial soit suffisamment lent (doux) pour que le front de ce décollement avance à la vitesse de mouillage du liquide 50 sur la surface 20s du substrat de croissance 20.

De préférence, une lame d'épaisseur inférieure à 500 µm, de préférence inférieure à 300 µm, et par exemple d'épaisseur 100 µm peut être utilisée pour exercer la première sollicitation mécanique.

Lorsque l'épaisseur de la lame est comprise entre 500 µm et 100 µm, la vitesse de propagation du décollement initial est généralement bien supérieure à la vitesse de mouillage du liquide 50 sur la surface 20s du substrat de croissance formant l'interface I1. Le décollement peut alors avoir lieu parfois à l'interface I2 comme expliqué précédemment.

Pour réduire l'étendue de ce décollement initial, et ainsi transférer au maximum le matériau 2D, l'épaisseur de la lame peut être avantageusement diminuée à 100 µm ou moins. Cela permet de contrôler la vitesse de propagation du front Fa du décollement initial pour qu'elle soit suffisamment faible pour éviter ou minimiser un mauvais décollement initial. En pratique, la lame L est reliée à un moyen de motorisation linéaire configuré pour déplacer la lame L à une vitesse qui est de préférence inférieure ou égale à 100 µm/s.

La vitesse d'insertion de la lame L peut alors être choisie inférieure ou égale à 100 µm/s, de préférence inférieure ou égale à 10 µm/s, de préférence encore inférieure ou égale à 1 µm/s, ce qui correspond, respectivement à une vitesse de propagation du front de décollement inférieure ou égale à 100 µm/s, de préférence inférieure ou égale à 10 µm/s, de préférence encore inférieure ou égale à 1 µm/s.

De telles gammes de vitesses d'insertion (et de propagation de fissure) permettent d'augmenter la surface de matériau 2D transférée, puisque la zone correspondant au décollement initial, où le matériau 2D n'est pas transféré, est réduite. Par exemple, cette zone peut représenter moins de 10 % de la superficie du matériau 2D.

Ensuite, la sollicitation mécanique se poursuit pour propager le décollement initial et ainsi le développer en la fissure interfaciale F. On note « deuxième sollicitation mécanique » cette deuxième phase de sollicitation mécanique. En d'autres termes, la deuxième sollicitation mécanique « prend le relais » de la première sollicitation mécanique.

La deuxième sollicitation mécanique peut être identique à la première sollicitation mécanique en ce qu'elle peut être effectuée avec le même moyen de contrainte (ex. lame, coin, fil, anneaux, mors). Par exemple, la même lame L que celle décrite précédemment peut être utilisée, et être insérée avec la même vitesse d'insertion que celle configurée pour la première sollicitation mécanique, à savoir une vitesse inférieure ou égale à 100 µm/s, de préférence inférieure ou égale à 10 µm/s, de préférence encore inférieure ou égale à 1 µm/s.

Alternativement, la vitesse d'insertion peut être plus faible lors de la première sollicitation mécanique que lors de la deuxième sollicitation mécanique. Cela permet de compenser la vitesse de progression du décollement initial qui est rapide comparée à celle de la progression de la fissure F. Par exemple, la vitesse d'insertion de la lame durant la première sollicitation mécanique est inférieure ou égale à 1 µm/s et la vitesse d'insertion de la lame durant la deuxième sollicitation mécanique est inférieure ou égale à 100 µm/s et supérieure à 1 µm/s. Une lame d'épaisseur variable (plus fine pour amorcer la fissure que pour la propager) peut aussi être envisagée.

Cette deuxième sollicitation mécanique est exercée sur l'assemblage 40 jusqu'à l'achèvement de la rupture interfaciale I1.

La température du liquide 50 peut être régulée entre 15 °C et 25 °C, par exemple à 20 °C.

Avantageusement, la température du liquide 50 peut être abaissée de manière à augmenter in-situ l'angle de contact de la surface 30s du substrat cible 30. Cela permet d'augmenter le caractère non-mouillant de cette surface 30s. La rupture interfaciale est alors plus efficace. La température du liquide 50 est de préférence supérieure ou égale 5 °C et inférieure ou égale à 10 °C.

Ainsi, grâce au caractère mouillable de la surface 20s du substrat de croissance 20 et au caractère non-mouillable de la surface 30s du substrat cible 30, ainsi qu'à la configuration de la sollicitation mécanique et à l'environnement extérieur de l'assemblage 40, on produit majoritairement, typiquement jusqu'à atteindre 90% de la surface du substrat de croissance, une rupture d'interface de type adhésive à l'interface I1 entre le matériau 2D 10 et le substrat de croissance 20. Cela permet de transférer le matériau 2D 10 avec succès sur une grande superficie (typiquement supérieure à 90% de la superficie du substrat de croissance).

En d'autres termes, grâce au caractère mouillable de la surface 20s du substrat de croissance 20 et au caractère non-mouillable de la surface 30s du substrat cible 30, à la configuration de la sollicitation mécanique et à l'environnement extérieur de l'assemblage 40, on évite de produire une rupture adhésive à l'interface I2 entre le matériau 2D 10 et le substrat cible 30, ce qui aboutirait à une absence de transfert du matériau 2D.

Le matériau 2D 10 est ainsi transféré depuis le substrat de croissance 20 vers le substrat cible 30 en évitant que le matériau 2D se retrouve sans support. Le procédé évite en outre, contrairement aux procédés de transfert de l'art antérieur, l'utilisation d'une couche support dédiée au maintien du matériau 2D (qui doit être formée puis retirée). Le substrat cible, qui est rigide (compte-tenu des épaisseurs des plaquettes et de leur module de Young), remplace cette couche support.

Cela permet d'éviter d'occasionner des déformations de type plis ou trous sur le matériau 2D, puisque le matériau 2D n'est jamais laissé sans soutien mécanique suffisant. Le procédé permet aussi de s'affranchir des étapes de formation et de retrait de la couche support sacrificielle. Il n'engendre aucun résidu de polymère ou métal, ni n'occasionne de détérioration, car aucun matériau n'est déposé sur le matériau 2D, contrairement aux procédés de transfert de l'art antérieur.

Il en résulte que le procédé des figures 1A-1C est particulièrement simple à mettre en oeuvre, compatible avec les environnements salle blanche de l'industrie microélectronique et permet le transfert de matériau 2D de grande superficie. En particulier, il peut être mis en oeuvre avec des plaquettes de 200 mm ou 300 mm de diamètre.

Le procédé des figures 1A-1C est applicable aussi bien à un matériau 2D monocouche qu'à un matériau 2D multicouche.

Lorsque le matériau 2D 10 est composé d'un seul feuillet mono-atomique ou mono-moléculaire, ce feuillet se détache du substrat de croissance 30 lors de l'étape de séparation.

Lorsque le matériau 2D 10 est composé d'un empilement de plusieurs (typiquement trois) feuillets mono-atomiques ou mono-moléculaires, cet empilement se détache en un bloc du substrat de croissance 30 lors de l'étape de séparation.

Un premier exemple de mise en oeuvre du procédé d'élaboration va maintenant être décrit.

### Étape S1

Un empilement de trois monocouches de MoS₂ a été obtenu sur un substrat de croissance 20 de 200 mm de diamètre, selon la méthode décrite dans le document [« Élaboration de monocouches de dichalcogénures de métaux de transition du groupe (VI) par chimie organométallique de surface », S. Cadot, Matériaux. Université de Lyon, 2016. Français. NNT : 2016LYSE1075. tel-01530918]. Cette méthode comprend une étape de dépôt par ALD à basse température (environ 100 °C) et une étape de cristallisation du matériau à haute température (900 °C) pour obtenir la structure lamellaire typique des matériaux 2D.

Le substrat de croissance 20 est une plaquette de 200 mm de diamètre qui comprend une couche de support (ou couche de base) en silicium et une couche superficielle en SiO₂, obtenue par exemple par oxydation thermique de la couche de support en silicium.

Selon une première variante de mise en oeuvre, la surface de la couche superficielle en SiO2 est nettoyée et présente un angle de contact de mouillage de moins de 10° avant la croissance du matériau 2D.

Selon une deuxième variante de mise en oeuvre, la surface de la couche superficielle n'est pas nettoyée et présente (à l'état naturel) un angle de contact de mouillage compris entre 20° et 30° avant la croissance du matériau 2D.

Le substrat cible 30 fourni est entièrement en silicium.

Afin d'augmenter l'angle de contact de goutte de la surface 30s du substrat cible 30, le substrat cible est traité en surface.

Le traitement de surface comprend une épitaxie de silicium sur la surface 30s du substrat cible. L'épitaxie est réalisée à l'aide de dichlorosilane (SiH₂Cl₂) à 950°C.

### L'épitaxie est décrite plus en détails ci-après.

La surface 30s du substrat cible 30 est d'abord préparée selon un procédé dit « HF last ». La préparation comprend un nettoyage chimique à base d'acide de caro (obtenue par un mélange d'acide phosphorique H₂SO₄ et d'eau oxygénée H₂O₂ à 120°C.

Le nettoyage est ensuite suivi d'un rinçage à l'eau désionisée, d'un traitement avec un mélange d'ammonique, d'eau oxygénée et d'eau dans des proportion 1/1/5 à 70°C.

Le rinçage est suivi d'une désoxydation dans un bain de HF à 0,1% en concentration massique suivie d'un rinçage à l'eau désionisée.

Chaque opération (nettoyage, rinçage, désoxydation) dure environ 10mn.

Après ce nettoyage et cette préparation chimique, on porte le substrat cible 30 à 950°C sous 20 mbar d'hydrogène pendant 2 minutes. On réalise alors l'épitaxie de silicium sur la surface préparée du substrat cible 30 pendant environ 10nm à 950°C sous 20 mbar de SiH₂CL₂.

Finalement, l'épitaxie se termine par un recuit de lissage à 950°C sous 20 mbar de dyhrogène H₂ pendant 5 min.

Des images de la surface épitaxiée du substrat cible 30 ont été acquises par microscopie à forces atomiques. Ces images montrent une très faible rugosité de surface, typiquement inférieure à 0,5 nm. Cette faible rugosité est parfaitement compatible avec un collage direct.

Après l'épitaxie la surface du substrat cible est passivée par de l'hydrogène grâce à un recuit sous atmosphère à base d'hydrogène. Cette surface du substrat cible présente un angle de contact de goutte compris entre 70° et 90°.

### Étape S2

Le substrat de croissance 20 et le substrat cible 30 sont ensuite assemblés, par collage direct entre le matériau 2D 10 et le silicium du substrat cible 30, de préférence à température ambiante et à l'air ambiant. Le collage est spontané avec la propagation d'une onde de collage assez rapide (environ 20 s pour parcourir les 200 mm de diamètre).

De préférence, le collage direct est réalisé juste après la croissance du matériau 2D pour éviter toute contamination particulaire.

Alternativement, le substrat de croissance et le matériau 2D sont stockés dans un environnement propre sans poussière ni contaminant d'hydrocarbure. Par exemple, ils sont stockés dans une boite spécifique comme celle fournie par la société Entegris (DMS Wafer Carrier 8" black antistatic TYP A5 n°780-550000005). Le collage reste identique même après 1 mois d'attente.

### Étape S3

La séparation du substrat de croissance 20 et du substrat cible 30 est accomplie en immersion dans de l'eau déionisée (EDI) régulée à 21°C.

L'assemblage du substrat de croissance et du substrat cible peut rester immergé avant la séparation pendant une journée. Il peut rester immergé plus longtemps, par exemple plus de 10 jours, sans qu'une dégradation du collage n'est ait observée.

La rupture de l'interface entre le substrat de croissance et le matériau 2D MoS₂ (et donc la séparation du substrat de croissance) est initiée par l'introduction d'une lame à une vitesse de 1 µm/s et une accélération de 10 µm²/s. Cette vitesse est régulée à l'aide d'un moteur linéaire. L'hydrophilie du SiO₂ (de la surface 20s du substrat de croissance 20) permet une avancée de l'eau déionisée à l'interface SiO₂/MoS₂ et une séparation des substrats à cette interface.

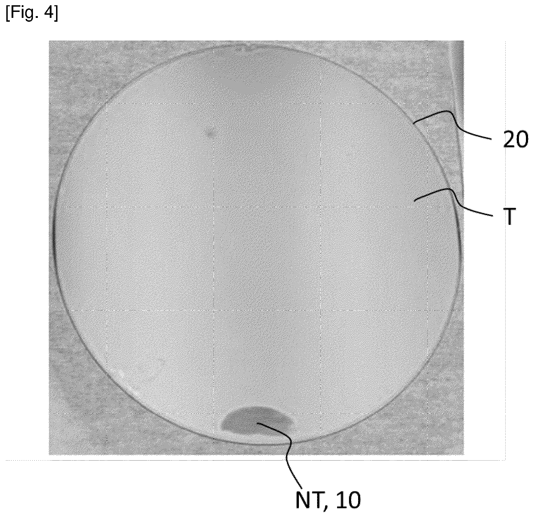

Le matériau 2D 10 est ainsi transféré sur le substrat cible 30 en silicium parce que l'interface entre le substrat cible et le matériau 2D, hydrophobe, ne subit aucune fracture interfaciale. Comme le montre la figure 4, toutes les monocouches de MoS2 sont ici transférées, sur 90 % de la surface du substrat cible (la zone en gris clair notée T correspond, sur cette photographie du substrat de croissance, aux zones où le matériau 2D 10 a été transféré. Les zones notées NT correspondent, quant à elles, aux zones où le matériau 2D 10 apparait car non-transféré).

Un deuxième exemple de mise en oeuvre du procédé d'élaboration va maintenant être décrit.

### Etape S1 :

Dans ce deuxième exemple, on utilise le même substrat de croissance 20 avec le même matériau 2D de MOS2 que lors du premier exemple de mise en oeuvre. Les opérations de préparation du substrat de croissance et de croissance du matériau 2D sont aussi identiques.

Le substrat cible 30 fourni est une autre plaquette de silicium de 200 mm de diamètre.

Ce substrat subit un traitement de surface qui diffère de celui mis en oeuvre dans le premier exemple.

Le traitement de surface comprend ici un nettoyage du substrat cible 30 à base d'acide de caro (obtenu par un mélange d'acide phosphorique H₂SO₄ et d'eau oxygénée H₂O₂ à 120°C).

Ensuite, le substrat cible 30 est rincé à l'eau désionisée.

Un nettoyage à base de SC1 composé d'un mélange d'eau, d'ammoniaque et d'eau oxygéné dans des proportions 5 :1 :1 à 70°C est ensuite mis en oeuvre sur le substrat cible rincé.

Ensuite, le substrat cible est placé dans une trempe d'une solution de HF à 10% massique pendant 20s. Cette opération permet de retirer l'oxyde natif et de passiver la surface en hydrogène.

Il est possible de faire un rinçage à l'eau désionisé pendant 10s sans perturber la passivation hydrogène.

### Etapes S2 et S3

Le collage S2 du substrat cible sur le matériau 2D et la séparation S3 du substrat de croissance sont identiques au premier exemple.

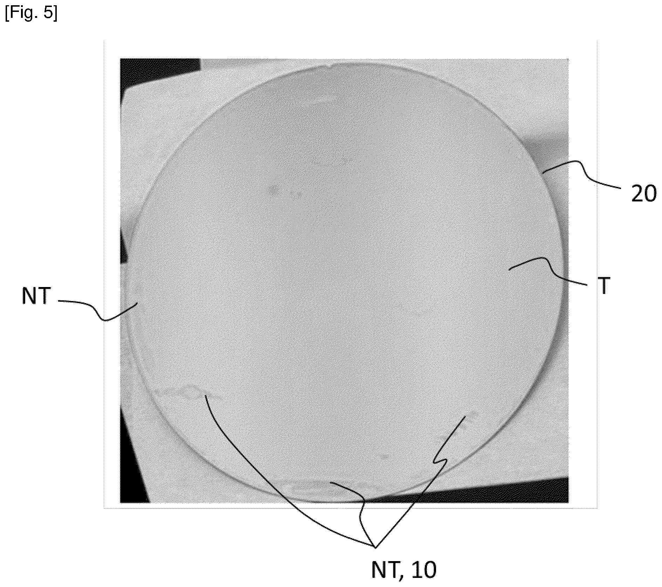

Comme le montre la figure 5, on obtient un transfert du matériau 2D légèrement moins bon, c'est-à-dire moins homogène et sur une superficie plus faible, que dans le premier exemple (cf. figure 4). Toutefois le matériau 2D est transféré à plus de 80 %, ce qui est satisfaisant pour beaucoup d'applications.

## Revendications

1. Procédé d'élaboration et de transfert d'un matériau bidimensionnel (10), comprenant les étapes suivantes :
- Croissance (S1) du matériau bidimensionnel (10) sur une surface (20s) d'un substrat de croissance (20) de sorte que le matériau bidimensionnel (10) soit lié à la surface (20s) du substrat de croissance (20) par des forces de van der Waals, la surface (20s) du substrat de croissance ayant un premier angle de contact (*θ*₁) avec une goutte d'un liquide (50) ;
- Fourniture (S1) d'un substrat cible (30), le substrat cible (30) présentant une surface (30s) ayant un deuxième angle de contact (*θ*₂) avec une goutte du liquide (50), le deuxième angle de contact (*θ*₂) étant strictement supérieur au premier angle de contact (*θ*₁) ;
- Assemblage (S2) du substrat de croissance (20) et du substrat cible (30) par collage direct entre le matériau bidimensionnel (10) et la surface du substrat cible (30s) ; et
- Rupture (S3) de l'interface (I1) entre le substrat de croissance (20) et le matériau bidimensionnel (10), en appliquant une sollicitation mécanique à l'assemblage (40) du substrat de croissance et du substrat cible pour générer et propager un front de fissure (Fa) à l'interface (11) entre le substrat de croissance (20) et le matériau bidimensionnel (10), et en plaçant l'assemblage (40) du substrat de croissance et du substrat cible dans un environnement tel qu'un front du liquide (50) se forme à l'interface (11) entre le substrat de croissance et le matériau bidimensionnel, la sollicitation mécanique étant configurée pour que le front du fissure (Fa) soit mouillé par le liquide (50).

2. Procédé selon la revendication 1, dans lequel l'écart (Δ*θ*) entre le premier et le deuxième angle de contact (*θ*₁, *θ*₂) est strictement supérieur à 10°, de préférence supérieur à 30°, de préférence supérieur à 50°.

3. Procédé selon l'une des revendications 1 à 2, dans lequel la fourniture du substrat cible (30) comprend un traitement de la surface (30s) du substrat cible (30) de manière à augmenter le deuxième angle de contact (*θ*₂).

4. Procédé selon l'une des revendications 1 à 3, comprenant, avant l'étape de croissance (S1) du matériau bidimensionnel (10), une étape de traitement de la surface (20s) du substrat de croissance (20) de manière à réduire le premier angle de contact (*θ*₁).

5. Procédé selon l'une des revendications 1 à 4, dans lequel la sollicitation mécanique est configurée pour permettre une avancée du front de fissure (Fa) à une vitesse inférieure ou égale à 100 µm/s, de préférence inférieure ou égale à 10 µm/s, de préférence encore inférieure ou égale à 1 µm/s.

6. Procédé selon l'une des revendications 1 à 5, dans lequel la sollicitation mécanique est exercée par une lame (L) d'épaisseur (e_{L}) inférieure ou égale à 500 µm, de préférence d'épaisseur (e_{L}) inférieure ou égale à 300 µm, de préférence encore inférieure ou égale à 100 µm.

7. Procédé selon la revendication 6, dans lequel l'épaisseur (e_{L}) de la lame (L) est inférieure ou égale à 100 µm, et la lame (L) est insérée à une première vitesse pour initier la fissure (F) et à une deuxième vitesse pour propager la fissure (F) dans l'interface (11) entre le substrat de croissance (20) et le matériau bidimensionnel (10), la première vitesse étant inférieure ou égale à 1 µm/s, et la deuxième vitesse étant supérieure à la première vitesse et inférieure ou égale à 100 µm/s.

8. Procédé selon l'une des revendications 1 à 7, dans lequel, lors de l'étape (S3) de rupture de l'interface (11) entre le substrat de croissance (20) et le matériau bidimensionnel (10), l'assemblage (40) du substrat de croissance et du substrat cible est placé dans le liquide (50).

9. Procédé selon l'une des revendications 1 à 8, dans lequel le liquide (50) est de l'eau déionisée ou une solution ionique.

10. Procédé selon l'une des revendications 1 à 7, dans lequel, lors de l'étape (S3) de rupture de l'interface (11) entre le substrat de croissance (20) et le matériau bidimensionnel (10), l'assemblage (40) du substrat de croissance et du substrat cible est placé dans un milieu gazeux comprenant de la vapeur d'eau déionisée ou de la vapeur d'une solution ionique.

11. Procédé selon l'une quelconque des revendications 1 à 10, dans lequel le matériau bidimensionnel (10) est du graphène, du nitrure de bore à structure cristalline hexagonale (h-BN) ou un dichalcogénure de métal de transition.

12. Procédé selon l'une quelconque des revendications 1 à 11, dans lequel la surface (20s) du substrat de croissance (20) et la surface (30s) du substrat cible (30) sont chacune formée d'un matériau choisi parmi le silicium (Si), le germanium (Ge), le dioxyde de silicium (SiO₂), le carbure de silicium (SiC), le phosphure d'indium (InP), l'arséniure de gallium (AsGa) et le saphir (Al₂O₃).

13. Procédé selon l'une quelconque des revendications 1 à 12, dans lequel la surface (20s) du substrat de croissance (20) est formée d'une couche de base de silicium ou de germanium recouverte d'une couche superficielle d'un matériau choisi parmi les matériaux suivants : dioxide de silicium (SiO2), nitrure de silicium (Si₃N₄), aluminium (AI), cuivre (Cu), titane (Ti), alumine (Al₂O₃), nickel (Ni), graphène.
